# EUROPEAN PATENT SPECIFICATION

(11) **EP 2 982 440 B1**
(45) Date of publication and mention of the grant of the patent: **27.03.2019**
(21) Application number: 15776545.4
(22) Date of filing: 08.04.2015
(51) Int. Cl.: B01L 3/02, G01N 1/00, B81B 1/00, G01N 37/00

(54) **ATTACHMENT FOR LIQUID INJECTION AND LIQUID INJECTION METHOD**
BEFESTIGUNG FÜR FLÜSSIGINJEKTION UND FLÜSSIGINJEKTIONSVERFAHREN
ACCESSOIRE POUR INJECTION DE LIQUIDE ET PROCÉDÉ D'INJECTION DE LIQUIDE

(30) Priority: 08.04.2014 JP 2014079268
(43) Date of publication of application: 10.02.2016
(73) Proprietor: NOK Corporation, Minato-ku Tokyo 105-8585 (JP)
(72) Inventor: UDA, Toru, Fujisawa-shi Kanagawa 251-0042 (JP); OKADA, Goki, Fujisawa-shi Kanagawa 251-0042 (JP); UMEBAYASHI, Hiroshi, Fujisawa-shi Kanagawa 251-0042 (JP); MUROTA, Yuki, Fujisawa-shi Kanagawa 251-0042 (JP)
(74) Representative: Thoma, Michael
(86) International application number: PCT/JP2015/061016
(87) International publication number: WO 2015/156331

(56) References cited:
- EP-A2- 1 724 017
- WO-A1-89/10191
- WO-A1-2004/065288
- DE-A1- 19 742 163
- JP-A- H02 503 883
- JP-A- 2003 098 150
- JP-A- 2006 322 850
- JP-A- 2008 232 951
- JP-A- 2012 147 751

## Description

### TECHNICAL FIELD

The present invention relates to a liquid injection attachment and a liquid injection method, and more particularly, to a liquid injection attachment used when, by means of a pipette, injecting liquid into a feed port through which liquid is introduced and a liquid injection method using the same.

### BACKGROUND

As is known by names such as micro total analysis systems (µTAS) or lab-on-chip, a microfluidic chip is gathering attention in which a microstructure including a microchannel and a port making up a flow path of a predetermined geometry is disposed within a substrate so that various operations such as chemical reaction, synthesis, refinement, extraction, generation, and/or analysis of substances are performed within the microstructure. The microfluidic chip is expected to be applied widely to uses in medical markets for genome analysis, genomic drug discovery, protein analysis, preventive diagnosis, clinical diagnosis, drug screening, etc., and uses in chemical analysis, food analysis, environmental monitoring, etc.

Furthermore, the microfluidic chip uses a smaller amount of samples and reagents, as compared with the conventional techniques and is disposable, enabling analysis process time to be shortened to a large extent. It can also reduce testing cost and show the testing result promptly.

The microfluidic chip needs a work to inject liquid such as a reagent through a liquid feeding tube from the feed port into the microchannel within the microfluidic chip. Ordinarily, at this time, a joint is required that links and fixes the liquid feeding tube and the microfluidic chip together at the feed port (Non-patent Literature: Microchemical Chip Technology and Application, published by MARUZEN Co:, Ltd., pp. 299-300). A method using an adhesive has been contrived as a method for fixing the liquid feeding tube and the microfluidic chip together at that time. However, use of the adhesive necessitates a process to adhere the liquid feeding tube and the microfluidic chip together, resulting in complicatedness.

It has thus been proposed that an attachment having a planar portion is mounted on a distal portion of a dispensing tip so that the circumference of the feed port is sealed by the planar portion during the liquid injection (Fig. 3 of JP-A-2012-147751). The attachment is made of a soft elastomer in whole and is shaped to have a circular section whose diameter decreases toward the distal portion. The attachment has at its central portion an aperture in which the distal portion of the dispending tip fits. Accordingly, by fitting this attachment to the distal portion of the dispending tip when liquid is injected, the injection work can be done with a more simply suppressed liquid leakage, without using the liquid feeding tube.

EP 1 724 017 A2 discloses a liquid injection attachment showing all features of the pre-characterising portion of claim 1.

DE 197 42 163 A1 shows a device used for perfusion treatment within a defined treatment area of a liquid bath.

### SUMMARY OF THE INVENTION

### PROBLEMS TO BE SOLVED BY THE INVENTION

However, since the attachment described in JP-A-2012-147751 is made of a soft elastomer in whole, a load large enough to compressively deform the entire attachment must be applied at the time of sealing in order to allow the planar portion to surely exhibit its sealing performance. As a result, the dispensing tip may undergo a deformation or damage. If the load is reduced to avoid the deformation or damage of the dispensing tip, the sealing performance tends to become unstable. It was therefore difficult for such an attachment to exhibit a stable sealing performance without a risk to deform or damage the dispensing tip.

Thus, an object of the present invention is to provide a liquid injection attachment enabling simple liquid injection into a feed port by merely mounting the attachment onto the distal portion of a pipette or a pipette tip when liquid is injected into the feed port, as well as capable of exhibiting an excellent sealing performance without a risk to deform or damage the pipette or the pipette tip, to thereby suppress leakage of liquid during the liquid injection.

Another object of the present invention is to provide a liquid injection method capable of exhibiting an excellent sealing performance without a risk to deform or damage the pipette or the pipette tip when injecting liquid into the feed port to thereby suppress leakage of liquid, as well as capable of simply performing the liquid injection work.

Other objects of the present invention will become apparent from the following descriptions.

### MEANS FOR SOLVING PROBLEMS

The above problems are solved by the liquid injection attachment of claim 1.

### EFFECT OF THE INVENTION

According to the present invention there can be provided a liquid injection attachment enabling a simple liquid injection into a feed port by merely mounting the attachment onto the distal portion of a pipette or a pipette tip when liquid is injected into the feed port, as well as capable of exhibiting an excellent sealing performance without a risk to deform or damage the distal portion of the pipette or the pipette tip, to thereby suppress leakage of liquid during the liquid injection.

According to the present invention there can also be provided a liquid injection method capable of exhibiting an excellent sealing performance without a risk to deform or damage the pipette or the pipette tip when injecting liquid into the feed port to thereby suppress leakage of liquid, as well as capable of simply performing a liquid injection work.

### BRIEF DESCRIPTION OF DRAWINGS

Fig. 1 is a perspective view, when used in a pipette, of an example of a liquid injection attachment.
Fig. 2 is a view showing respective examples of a micropipette and a pipette tip.
Fig. 3 is a sectional view of the liquid injection attachment shown in Fig. 1.
Fig. 4 is a sectional view, in use, explaining the function and effect of the liquid injection attachment shown in Fig. 1.
Fig. 5 is a sectional view, in use, of another example of the liquid injection attachment.
Fig. 6 is a sectional view, in use, of the liquid injection attachment according to the present invention.
Fig. 7 is a sectional view, in use, of a state where a load is applied to the liquid injection attachment shown in Fig. 6.
Fig. 8 is a sectional view, in use, of another example of the liquid injection attachment according to the present invention.
Fig. 9 is a view, viewed from the distal portion side, of the liquid injection attachment shown in Fig. 8.
Fig. 10(a) (b) is a sectional view, in use, explaining the function and effect of the liquid injection attachment shown in Fig. 8.
Fig. 11(a) is a view of another example of a stopper portion when viewed from the distal portion side of the liquid injection attachment, and (b) is a sectional view of the liquid injection attachment, showing a further example of the stopper portion.
Fig. 12 is a sectional view, in use, of a further example of the liquid injection attachment.
Fig. 13 is a sectional view, in use, of a state where a load is applied to the liquid injection attachment shown in Fig. 12.
Fig. 14 is a sectional view, in use, of a yet further example of the liquid injection attachment.
Fig. 15 is an explanatory view explaining an example of a liquid injection method.

### DESCRIPTION OF THE PREFERRED EMBODIMENTS

An embodiment of the present invention will now be described with reference to the drawings.

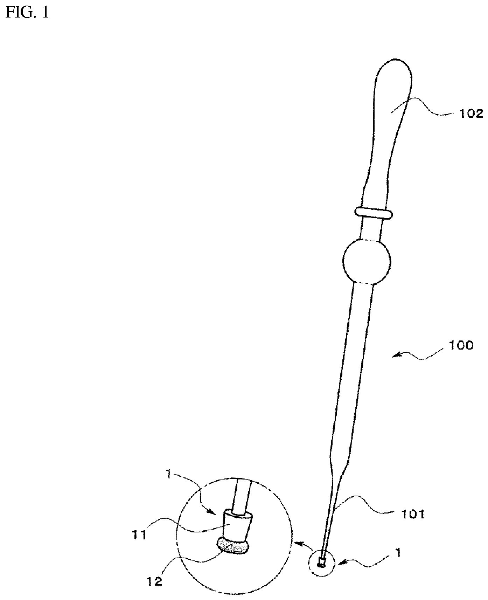

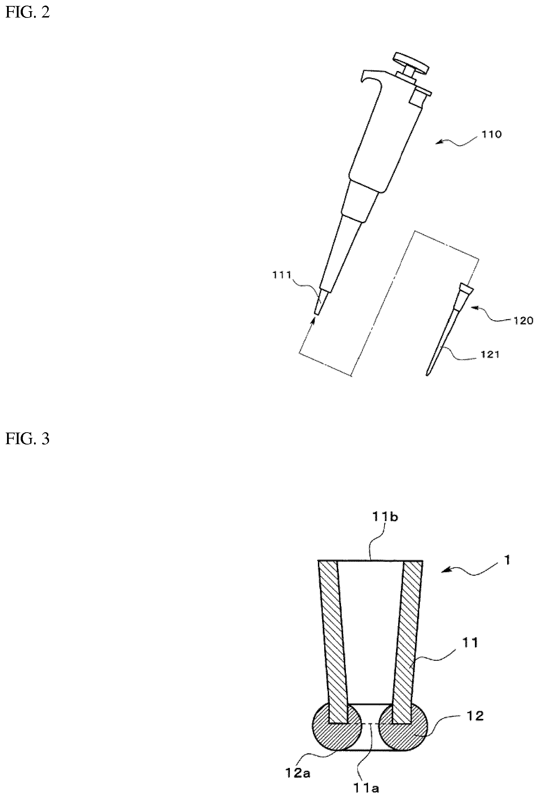

A liquid injection attachment according to the present invention is used when performing a liquid injection work using a pipette into a feed port of a microchannel, etc., of a microfluidic chip into which liquid is introduced. The pipette includes not only a pipette 100 as shown in Fig. 1 that draws and injects liquid by a rubber bulb 102 but also a micropipette 110 as shown in Fig. 2 used when drawing and injecting a minute amount of liquid in microliter range, both of which are included in the pipette of the present invention.

The liquid injection attachment according to the present invention is not limited to one that, when used, is removably mounted on a distal portion 101 of the pipette 100 or on a distal portion 111 of the micropipette 110. For example, as shown in Fig. 2, when used, it may be removably mounted on a distal portion 121 of a pipette tip 120 fitted to a distal end of the pipette 100 or the micropipette 110. The distal portion 101 of the pipette 100 and the distal portion 121 of the pipette tip 120 may usually be commercially available ones fabricated by an injection molding method, etc., using a thermoplastic resin as a molding material.

Although in this specification, description is given of the case where the liquid injection attachment is removably mounted on the distal portion 101 of the pipette 100 that draws and injects liquid by the rubber bulb 102 as shown in Fig. 1, the following description can apply to the case where it is mounted on the distal portion 111 of the micropipette 110 and on the distal portion 121 of the pipette tip 120 as shown in Fig. 2.

Fig. 1 is a perspective view of a state where the distal end of the pipette is mounted with an example of the liquid injection attachment, with a portion enclosed in a one-dotted chain circle being depicted in an enlarged scale. Fig. 3 is a sectional view of the liquid injection attachment shown in Fig. 1.

A liquid injection attachment 1 has an attachment body 11 mounted on the distal portion 101 of the pipette 100 and a gasket 12 retained by the attachment body 11.

The attachment body 11 has a tubular shape so as to be removably mounted on the outer periphery of the distal portion 101 of the pipette 100. A distal end (lower end in Fig. 3) of the attachment body 11 is a liquid outlet 11a through which liquid in the pipette 100 flows out, and a rear end (upper end in Fig. 3) is an insertion port 11b into which the distal portion 101 of the pipette 100 is inserted.

The attachment body 11 may be of a cylindrical shape with an unvarying inner diameter from the liquid outlet 11a toward the insertion port 11b. However, in order to ensure a favorable mountability onto the tapered distal portion 101 and prevent excessive insertion into the distal portion 101, it is preferred to be of a tapered funnel shape with gradually reduced diameters from the insertion port 11b toward the liquid outlet 11a. The inner surface of the attachment body 11 is shaped into a funnel that axially inclines at a certain angle as shown in Fig. 3.

The attachment body 11 is typically formed from a harder material than that of the gasket 12 in order to enable a stable mounting on the distal portion 101 to be maintained, while enabling the gasket to be stably retained. There is no particular limitation to a specific material, but it is preferred to be a synthetic resin easy to mold at a low cost. Although a specific synthetic resin is properly selected depending on the type of liquid, it may be for example a thermoplastic resin such as polyethylene and polypropylene.

The gasket 12 is formed from a rubber-like elastic body. The gasket 12 is disposed around the liquid outlet 11a so as to surround the liquid outlet 11a of the attachment body 11. The gasket 12 is formed by an O-ring with a circular section and further protrudes from the liquid outlet 11a toward the distal end side (lower side in Fig. 3) of the attachment body 11.

The gasket 12 is a member separate from the attachment body 11 and hence may be formed from a material with superior sealing properties that is specialized to sealing performances. This increases the range of selection of an available gasket material, as compared with the conventional case where the entire attachment is formed from an elastic body.

The rubber-like elastic body forming the gasket 12 may optionally be selected depending on the material used as the attachment body 11 and on the type of liquid. For example, it may be a silicone rubber, a fluororubber, an acrylic rubber, a nitrile rubber, a butyl rubber, etc. The gasket 12 is typically molded directly integral with the attachment body 11, but a separately molded gasket 12 may be adhered to the circumference of the liquid outlet 11a.

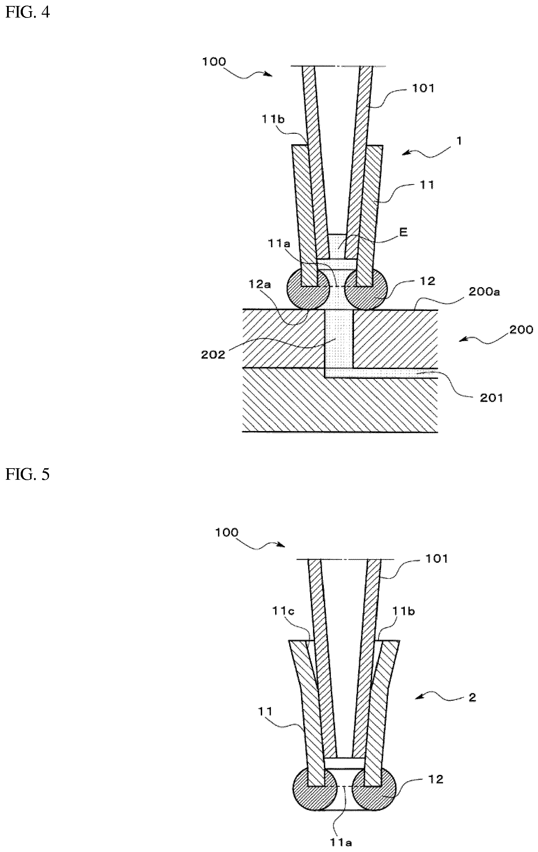

The function and effect of the liquid injection attachment 1 will then be described by way of an example where liquid E is injected into a feed port 202 of a microchannel 201 formed in a microfluidic chip 200 as shown in Fig. 4.

When injecting liquid E within the pipette 100 into the microchannel 201 of the microfluidic chip 200, first the liquid injection attachment 1 is mounted on the distal portion 101 of the pipette 100. Afterward, the liquid injection attachment 1 is pressed against a top surface 200a of the microfluidic chip 200 so that the gasket 12 abuts against the circumference of the feed port 202.

At this time, a slight load is applied to the liquid injection attachment 1 so that the gasket 12 is compressively deformed to cause the gasket 12 to produce a reaction force arising from the compressive deformation. The liquid injection attachment 1 effectively utilizes, during the liquid injection, the reaction force generated by the compressive deformation of the gasket 12 in this manner. Thus, this reaction force of the gasket 12 counteracts the injection pressure during the liquid injection. For this reason, the liquid injection attachment 1 exhibits a favorable sealing performance so that liquid E is introduced from the pipette 100 via the liquid outlet 11a and the feed port 202 into the microchannel 201 without leakage of liquid E to the exterior.

In this liquid injection attachment 1, the portion exhibiting the sealing performance due to the compressive deformation is only the gasket 12 disposed on the distal end of the attachment body 11. For this reason, the load applied at the time of sealing may be a small load enough to compressively deform only the gasket 12, and a large load need not be applied as in the conventional attachment whose entirety is formed from elastomer. When applying a load to the gasket 12, the distal portion 101 of the pipette 100 is peripherally supported by the tubular attachment body 11. Hence, according to this liquid injection attachment 1, during the liquid injection, the gasket 12 is easily compressively deformed with a small load so that a favorable sealing performance can be exhibited, without incurring a deformation or damage of the distal portion 101.

The liquid injection attachment 1 has a reduced number of components and a simple configuration, resulting in a lower production cost. Furthermore, the liquid injection attachment 1 is disposable and therefore does not need a cleaning work. Thus, liquid contamination is prevented.

The gasket 12 shown in this illustrative example is formed by the O-ring. The gasket 12 comprised of the O-ring has at its distal end a lip 12a with an arc-shaped section. Thereby, when the gasket 12 is pressed against the top surface 200a of the microfluidic chip 200, a contact surface pressure (seal surface pressure) is maximized by the arc-shaped distal end (lip 12a). Hence, as compared with the case of sealing by the planar portion as in the conventional attachment, a superior sealing performance can be exerted so that the liquid leakage suppression effect during the liquid injection can be enhanced.

Such a liquid injection attachment 1 is applicable to an automatic pipette device or a pipetting robot. This enables the liquid injection works to be automated. Further, by mounting it on each of distal portions of a multichannel pipette, liquid can simultaneously be injected into a plurality of feed ports.

Fig. 5 is a sectional view, in use, of another example of the liquid injection attachment. Since portions designated by the same reference numerals as those of the liquid injection attachment 1 shown in Figs. 1 to 4 are portions with the same features, the above explanations will apply to those explanations, which will therefore be omitted herein.

This liquid injection attachment 2 differs from the liquid injection attachment 1 in that the inner surface on the insertion port 11b side of the attachment body 11 has a tapered shape that further opens outward.

More specifically, although similar to the liquid injection attachment 1, this liquid injection attachment 2 has a tapered funnel shape that gradually reduces in diameter from the insertion port 11b toward the liquid outlet 11a, the insertion port 11b side of the attachment body 11 is shaped so as to further expand outward. As a result, the inner surface of the attachment 11 has a taper surface 11c whose inclination angle varies at a midway portion in the axial direction and which inclines so as to further open outward from the midway portion toward the insertion port 11b. The taper surface 11c is shaped in such a manner that it gradually radially expand from the midway portion of the attachment body 11 toward the insertion port 11b without coming into contact with the outer peripheral surface of the distal portion 101 when inserting the distal portion 101 of the pipette 100 into the insertion port 11b.

According to this liquid injection attachment 2, the following effect is provided in addition to the effect presented by the liquid injection attachment 1 described above. Since the liquid injection attachment 2 has an expanded opening on the insertion port 11b side, the distal portion 101 can smoothly be guided along the taper surface 11c into the insertion port 11b even if the center axis of the distal portion 101 is offset from the center axis of the attachment body 11 when mounting on the distal portion 101 of the pipette 100. This results in an improvement in workability for mounting on the distal portion 101.

Such an effect is particularly noticeable in the case of applying the liquid injection attachment 2 to an automatic liquid injection system that uses the automatic pipette device or the pipetting robot. That is, in the case of fitting together the distal portion of the automatic pipette device or the pipetting robot and the attachment, a high positioning accuracy is required for a linear motion mechanism, etc. In some cases, a high machining accuracy is required for the distal portion and the attachment. For this reason, a costly automatic pipette device or pipetting robot may be required.

According to this liquid injection attachment 2, however, since the opening of the insertion port 11b is expanded by the taper surface 11c, the distal portion 101 can smoothly be guided along the taper surface 11c into the insertion port 11b, without needing especially a high positioning accuracy and machining accuracy even when automatically mounted on the distal portion 101, thereby enabling secure fitting with the distal portion 101 to be performed at a low cost.

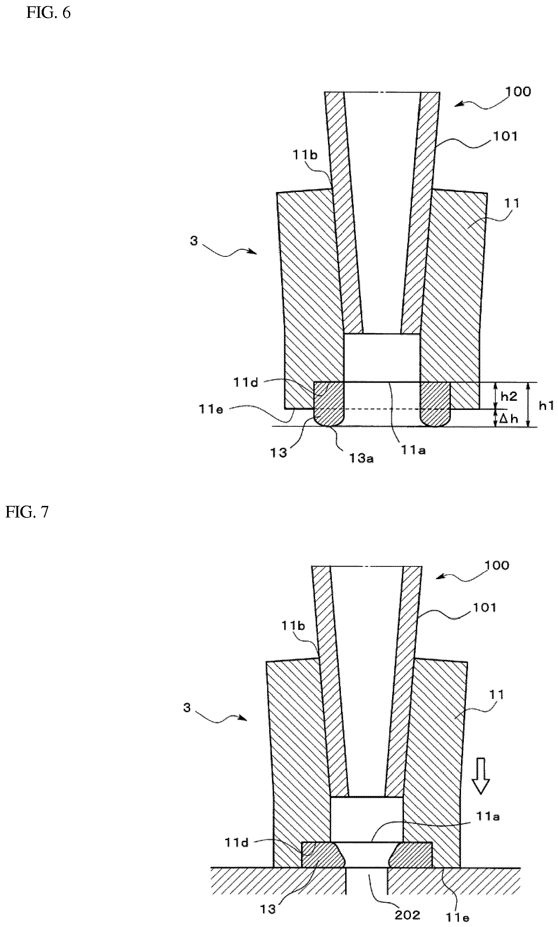

Fig. 6 is a sectional view, in use, of the liquid injection attachment according to the present invention. Since portions designated by the same reference numerals as those of the liquid injection attachment 1 shown in Figs. 1 to 4 are portions with the same features, the above explanations will apply to those explanations, which will therefore be omitted herein.

This liquid injection attachment 3 differs from the liquid injection attachment 1 in a structure to fit a gasket to the attachment body 11.

More specifically, the liquid injection attachment 3 includes a stepped portion 11d disposed so as to surround the liquid outlet 11a of the attachment body 11. The stepped portion 11d is axially circularly recessed from a distal end surface 11e of the attachment body 11 and is coaxial with the liquid outlet 11a. The liquid outlet 11a opens in a bottom surface of the stepped portion 11d.

On the other hand, a gasket 13 is annularly formed by the same rubber-like elastic body as in the gasket 12 of the liquid injection attachment 1 and is fixedly adhered to the inside of the stepped portion 11d. With being received in the stepped portion 11d, the gasket 13 protrudes on its distal end side from the distal end surface 11e of the attachment body 11. Preferably, the protruding distal end of the gasket 13 is shaped into an arc as shown in Fig. 6 to thereby have a lip 13a similar to that of the gasket 12 comprised of the O-ring of the liquid injection attachment 1 described above.

According to this liquid injection attachment 3, the following effect is provided in addition to the effect presented by the liquid injection attachment 1 described above. In the case that upon the liquid injection, an excessive load is applied to compressively deform the gasket 13, the distal end surface 11e of the attachment body 11 comes into abutment against the circumference of the feed port 202 as shown in Fig. 7 so that the distal end surface 11e serves as a stopper. Thus, according to this liquid injection attachment 3, an excessive compressive deformation of the gasket 13 can be prevented enabling a stable sealing performance to be maintained.

Such an effect is particularly noticeable in the case of application to the automatic liquid injection system that uses the automatic pipette device or the pipetting robot. That is, in the case that the distal portion of the automatic pipette device or the pipetting robot and the liquid injection attachment are automatically fitted together, a lowered accuracy in the positioning control of the distal portion in the height direction or a lowered machining accuracy of the distal portion or the insertion port 11b of the attachment body 11 may bring about a variation in the insertion height of the distal portion relative to the insertion port 11b of the attachment body 11. At this time, if the load during the liquid injection is controlled to be constant, a load applied to the gasket also varies, with the result that the gasket may excessively be compressed. According to this liquid injection attachment 3, even though an excessive load is applied to the gasket 13, the distal end surface 11e of the attachment 11 can serve as a stopper to prevent an excessive compression, consequently enabling a stable sealing performance to be maintained. There is no need to use a costly automatic pipette device or pipetting robot capable of controlling the position in the height direction at a high accuracy as well as to keep the machining accuracy of the insertion port 11b of the attachment body 11 at a high level.

As shown in Fig. 6, it is preferred in this liquid injection attachment 3 that h1>h2 where h1 is an axial height of the gasket 13 and h2 is an axial depth of the stepped portion 11d and that a difference Δh(=h1-h2) between h1 and h2 be set to lie between a minimum allowable displacement and a maximum allowable displacement of the gasket 13. The minimum allowable displacement and the maximum allowable displacement are a minimum value and a maximum value of the displacement that can maintain the sealing performance of the gasket. As a result, the liquid injection attachment 3 can exert a stable sealing performance by the gasket 13 more preferably over the range from abutment of the gasket 13 against the circumference of the feed port 202 up to abutment of the distal end surface 11e against the circumference of the feed port 202.

There is no particular limitation to a specific numeral value, but by way of example, the difference Δh=0.4 mm where h1=2 mm and h2=1.6 mm. In this case, the maximum displacement of the gasket 13 is 20 %, enabling a sufficient sealing performance to be exerted.

Naturally, this liquid injection attachment 3 may be formed with the taper surface 11c (Fig. 5) that further opens outward in the inner surface on the insertion port 11b side of the attachment body 11, similar to the liquid injection attachment 2 described above.

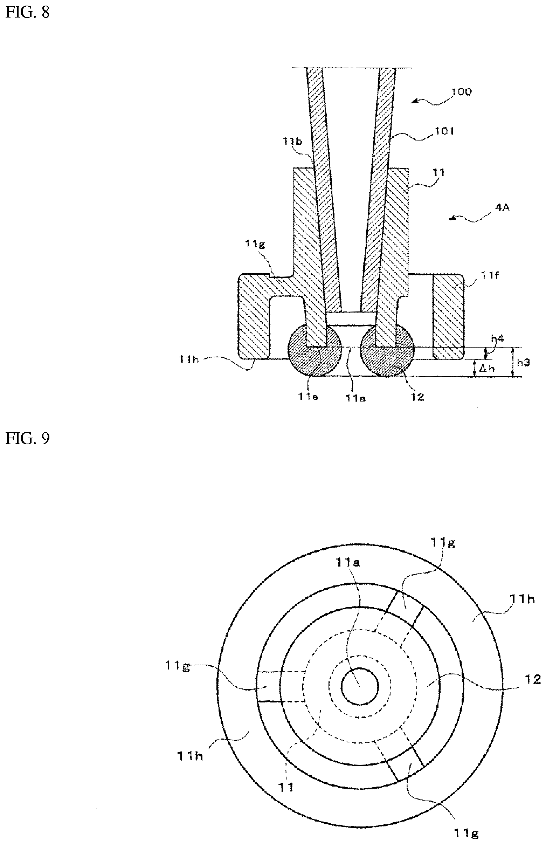

Fig. 8 is a sectional view, in use, of another example of the liquid injection attachment according to the present invention, and Fig. 9 is a view, viewed from the distal portion side, of the liquid injection attachment shown in Fig. 8. Since portions designated by the same reference numerals as those of the liquid injection attachment 1 shown in Figs. 1 to 4 are portions with the same features, the above explanations will apply to those explanations, which will therefore be omitted herein.

This liquid injection attachment 4A differs from the liquid injection attachment 1 described above in that the attachment body 11 has a tilt prevention stopper portion 11f.

More specifically, the attachment body 11 of this liquid injection attachment 4A includes the stopper portion 11f disposed on the outer peripheral side of the gasket 12 and protruding toward the distal end side relative to the liquid outlet 11a.

The stopper portion 11f shown in this embodiment is of a cylindrical shape and is shaped coaxially with the attachment body 11 in such a manner as to surround the gasket 12 apart a certain distance from the outer periphery of the gasket 12. The stopper portion 11f is connected to the attachment body 11 by an appropriate number of connecting portions 11g. A distal end surface 11h of the stopper portion 11f is positioned protruding toward the distal end side relative to the distal end surface 11e of the attachment body 11, while the gasket 12 further protrudes toward the distal end side relative to the distal end surface 11h of the stopper portion 11f.

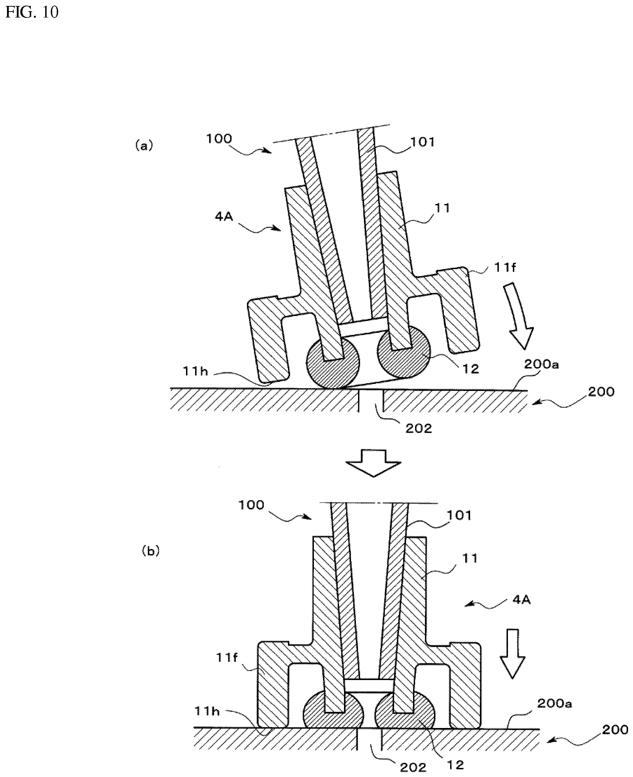

According to this liquid injection attachment 4A, the following effect is provided in addition to the effect presented by the liquid injection attachment 1 described above. In the case that, when the liquid injection attachment 4A is abutted against the circumference of the feed port 202 upon the liquid injection, the pipette 100 and the liquid injection attachment 4A are not perpendicular to the top surface 200a of the microfluidic chip 200, with the load center of gravity being tilted, as shown in Fig. 10(a), the distal end surface 11h of the stopper portion 11f comes into abutment against the top surface 200a on the outer peripheral side of the gasket 12. As a result, the stopper portion 11f supports the tilted liquid injection attachment 4A to restrain it from tilting more excessively. Then, with the distal end surface 11h of the stopper portion 11f abutted against the top surface 200a as a fulcrum, the tilt of the pipette 100 and the liquid injection attachment 4A can easily be corrected. This enables the gasket 12 to be compressively deformed for liquid injection while constantly keeping the pipette 100 and the liquid injection attachment 4A at their preferred postures with respect to the top surface 200a of the microfluidic chip 200. Thus, the favorable sealing performance during the liquid injection can further be improved.

In the case that an excessive load is applied at the time of compressive deformation of the gasket 12, the distal end surface 11h of the stopper portion 11f comes into abutment against the circumference of the feed port 202 as shown in Fig. 10(b) so that the stopper portion 11f functions also as a stopper. For this reason, according to this liquid injection attachment 4A, the gasket 12 is prevented from being excessively compressed so that a stable sealing performance can be maintained.

Such an effect is particularly noticeable in the case of application to the automatic liquid injection system that uses the automatic pipette device or the pipetting robot. That is, as described in the liquid injection attachment 3, even in the case that an excessive load is applied due to a variation in the insertion height of the attachment body 11 relative to the distal portion 101, according to this liquid injection attachment 4A, the distal end surface 11h of the stopper portion 11f functions as a stopper as shown in Fig. 10(b). For this reason, the gasket 12 is prevented from being excessively compressed so that a stable sealing performance can be maintained. There is no need to use a costly automatic pipette device or pipetting robot capable of controlling the position in the height direction at a high accuracy as well as to keep the machining accuracy of the insertion port 11b of the attachment body 11 at a high level.

As shown in Fig. 8, it is preferred in the liquid injection attachment 4A that h3>h4 where h3 is a protrusion height of the gasket 12 from the distal end surface 11e of the attachment body 11 and h4 is a protrusion height of the stopper portion 11f from the distal end surface 11e of the attachment body 11 and that a difference Δh(=h3-h4) between h3 and h4 be set to lie between a minimum allowable displacement and a maximum allowable displacement of the gasket 12. The minimum allowable displacement and the maximum allowable displacement are a minimum value and a maximum value of the displacement that can maintain the sealing performance of the gasket. As a result, the liquid injection attachment 4A can exert a stable sealing performance by the gasket 12 more preferably over the range from abutment of the gasket 12 against the circumference of the feed port 202 up to abutment of the distal end surface 11h of the stopper portion 11f against the circumference of the feed port 202.

There is no particular limitation to a specific numeral value, but by way of example, the difference Δh=0.4 mm where h3=2 mm and h4=1.6 mm. In this case, the maximum displacement of the gasket 12 is 20 %, enabling a sufficient sealing performance to be maintained.

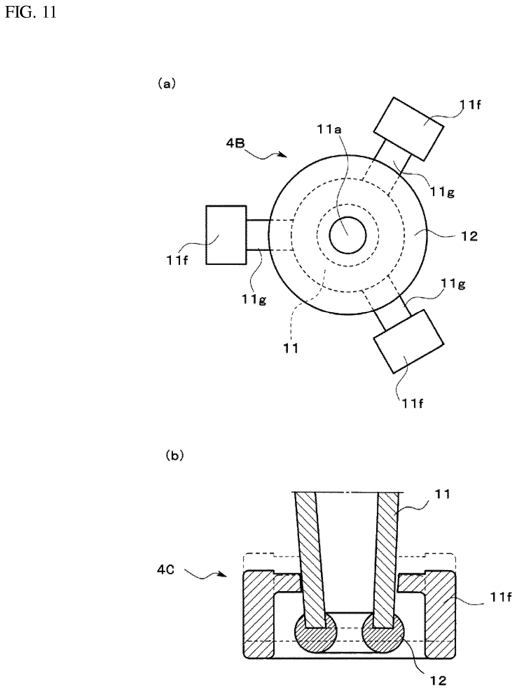

The stopper portion 11f shown in Figs. 8 and 9 is shaped into a cylinder. This is a preferred mode because the pipette 100 and the liquid injection attachment 4A can easily return vertically even though they are tilted in any direction through 360 degrees. However, as in a liquid injection attachment 4B shown in Fig. 11(a) for example, the stopper portion 11f may partly be arranged at three or more locations equiangularly around the liquid outlet 11a.

The stopper 11f is not limited to one formed integrally with the attachment body 11. As in a liquid injection attachment 4C shown in Fig. 11(b) for example, the stopper portion 11f may be formed separately from the attachment body 11. It is preferred in this case that the stopper 11f be removably amounted on the outer peripheral surface of the attachment body 11. Since the stopper portion 11f may be disposed as the need arises, unnecessary use of the stopper portion 11f can be eliminated.

It is natural that these liquid injection attachments 4A to 4C may also be formed with the taper surface 11c (Fig. 5) that further opens outward in the inner surface on the insertion port 11b side of the attachment body 11, similar to the liquid injection attachment 2 described above.

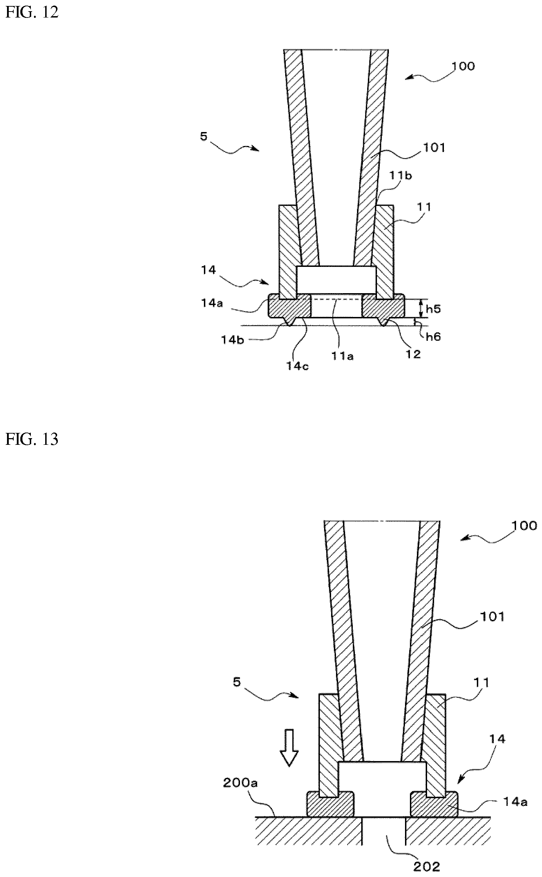

Fig. 12 is a sectional view, in use, of a further example of the liquid injection attachment. Since portions designated by the same reference numerals as those of the liquid injection attachment 1 shown in Figs. 1 to 4 are portions with the same features, the above explanations will apply to those explanations, which will therefore be omitted herein.

This liquid injection attachment 5 includes a gasket that is different in shape from the gasket 12 of the liquid injection attachment 1 described above.

The gasket 14 of this liquid injection attachment 5 is formed from an elastic body similar to that of the gasket 12 of the liquid injection attachment 1 described above, but differs therefrom in that the distal end of a gasket body 14a is structured to have a lip 14b integrally formed therewith that, when subjected to a load, easily deforms to provide sealing.

The gasket body 14a is an annular body with a rectangular section and is disposed around the liquid outlet 11a of the attachment body 11. A distal end surface 14c of this gasket body 14a is a planar surface. On the other hand, the lip 14b is an annular ridge that protrudes integrally from a part of the distal end surface 14c of the gasket body 14a.

According to this liquid injection attachment 5, the following effect is provided in addition to the effect presented by the liquid injection attachment 1 described above. Since the gasket 14 has the protruding lip 14b at its distal end, this lip 14b abuts against the top surface 200a around the feed port 202 during the liquid injection. Then, when a load is applied to the gasket 14, the lip 14b easily deforms to seal the circumference of the feed port 202 as shown in Fig. 13. This can increase the seal surface pressure to further improve the sealing performance. When considering the gasket 14 as a whole, the deformation volume is small because the lip 14b has an extremely small volume. For this reason, the load applied during sealing may be a smaller one.

This liquid injection attachment 5 exerts a particularly excellent effect when applied to an automatic pipette device or a dispensing device that uses a plurality of pipettes for simultaneous liquid injection. More specifically, in the automatic pipette device or the dispensing device, the deformation amount of each gasket is influenced not only by the control accuracy in the height direction of the device but also by the tolerance in the height direction of each of the pipettes. In this case, if the accuracy in the height direction of the device or the accuracy in the height direction of each pipette is low, not only the deformation amount of each gasket differs, but the reaction force when abutted against the microfluidic chip also varies, which may bring about a variation of the sealing performance for each liquid injection attachment.

According to this liquid injection attachment 5, however, the lip 14b protruding a predetermined height from the gasket body 14a can accommodate not only the variation of the deformation amount attributable to the variation in the height direction of the device or the pipettes but also the variation of the reaction force from the microfluidic chip 200. For this reason, even in the case that the accuracy in the height direction of the device or the accuracy in the height direction of each pipette is low, the lip 14b can eliminate the variation of the sealing performance for each liquid injection attachment 5 to maintain a stable sealing performance.

It is preferred for the gasket 14 that h5>h6 where h5 is an axial height of the gasket body 14a and h6 is an axial height of the lip 14b as shown in Fig. 12. Since the gasket body 14a higher in height (thicker in thickness) is disposed at the root of the lip 14b, it is possible to restrain the lip 14b from falling down. Since the volume of the lip 14b is sufficiently smaller than that of the gasket body 14, the reaction force becomes smaller when the lip 14b is compressively deformed. This allows the lip 14b to exert a secure sealing performance even when a small load is applied thereto.

The lip 14b shown in Fig. 12 is of a triangular section, but is not particularly limited to a specific sectional shape. There is also no particular limitation to specific dimensions of the lip 14b. To give an example of the dimensions, the radius of curvature R of the distal end of the lip 14b can be 0.1-0.4 mm, preferably 0.1-0.3 mm. The angle θ at the distal end of the lip 14b can be 0-60 degrees, preferably 15-45 degrees. The height h6 of the lip 14b can be 0.05-1.0 mm, preferably 0.1-0.3 mm.

The gasket 14 of this liquid injection attachment 5 may be used in place of the gaskets 12 and 13 of the liquid injection attachments 2, 3, and 4A-4C described above.

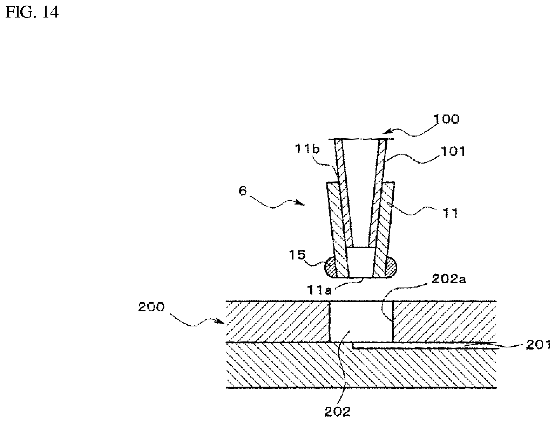

Fig. 14 is a sectional view, in use, of a yet further example of the liquid injection attachment. Since portions designated by the same reference numerals as those of the liquid injection attachment 1 shown in Figs. 1 to 4 are portions with the same features, the above explanations will apply to those explanations, which will therefore be omitted herein.

This liquid injection attachment 6 presents a structure that is preferably applicable when the diameter of the feed port 202 of the microfluidic chip 200 is greater than the outer diameter of the distal end of the attachment body 11.

More specifically, a gasket 15 of this liquid injection attachment 6 is disposed on the outer side surface of the distal portion of the attachment body 11 so as to provide a seal between the distal portion and an inner peripheral surface (rising side surface) 202a.

The gasket 15 is formed from an elastic body similar to that of the gasket 12 of the liquid injection attachment 1 described above and is disposed protruding radially outward from the outer peripheral surface of the attachment body 11. The outer diameter of this gasket 15 is formed to be slightly larger than the inner diameter of the inner peripheral surface 202a of this gasket 15. Although this gasket 15 is shaped into an arc in section, it may be of a trapezoidal section, a triangular section, etc., as long as it has a radially protruding form.

As a result, when the liquid injection attachment 6 fits into the feed port 202 of the microfluidic chip 200 upon the liquid injection, the gasket 15 serves as a lip whose distal end (lip distal end) maximizes the contact surface pressure (seal surface pressure), thereby providing an excellent seal between the attachment body 11 and the inner peripheral surface 202a of the feed port 202.

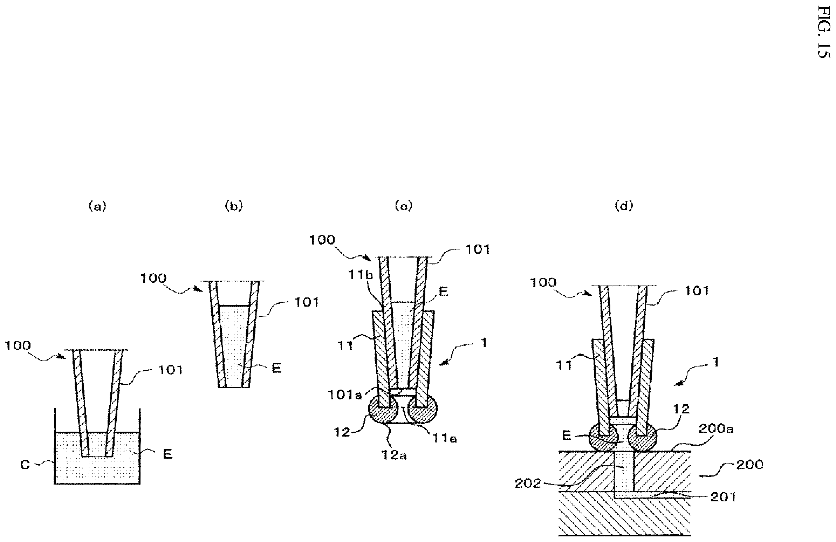

Referring next to Fig. 15, description will be given of an example of a liquid injection method using such a liquid injection attachment.

Description herein is given by way of example of the case where the liquid injection attachment 1 shown in Figs. 1 to 4 is used to inject liquid into the microchannel 201 of the microfluidic chip 200. However, the liquid injection method according to the present invention may similarly use the liquid injection attachments 3 and 4A-4C described above, to inject liquid.

Liquid E such as a reagent contained in a sample container C such as a microtube, a sample tube, a vial, a test tube, a Spitz tube, and a conical tube is drawn and sampled by the distal portion 101 of the pipette 100 (Fig. 15(a)). At this point of time, the liquid injection attachment 1 is not yet mounted on the distal portion 101 of the pipette. After drawing and sampling liquid E, the pipette 100 is retrieved from the sample container C (Fig. 15(b)).

The distal portion 101 of the pipette 100 is then inserted into the insertion port 11b of the liquid injection attachment 1 to mount the liquid injection attachment 1 onto the distal portion 101 (Fig. 15(c)). The mounting of the liquid injection attachment 1 is completed when the inner peripheral surface of the attachment body 11 comes into intimate contact with the outer peripheral surface of the distal portion 101 so that a further insertion is prevented. Upon the completion of mounting of the liquid injection attachment 1, a distal end surface 101a of the distal portion 101 is positioned slightly apart from the gasket 12 of the liquid injection attachment 11 toward the insertion port 11b. This eliminates the risk that the distal portion 101 may collide with the gasket 12 and consequently the gasket 12 may disengage from the attachment body 11.

The pipette 100 is then forced toward the feed port 202 for introducing liquid into the microchannel 201 of the microfluidic chip 200. In other words, the gasket 12 of the liquid injection attachment 1 mounted on the distal portion 101 of the pipette 100 is brought into abutment against the circumference of the feed port 202 disposed in the top surface 200a of the microfluidic chip 200 (Fig. 15(d)). Since this gasket 12 is formed to have an outer diameter greater than the diameter of the feed port 202, the gasket 12 abuts against the top surface 200a of the microfluidic chip 200 so as to surround the opening circumferential portion of the feed port 202, to provide a seal therebetween.

Liquid E within the pipette 100 is then injected into the microchannel 201 of the microfluidic chip 200 by the injection pressure of the pipette 100. At this time, the gasket 12 of the liquid injection attachment 1 is compressively deformed generating a reaction force. As a result, liquid E is introduced from the pipette 100 through the liquid outlet 11a of the liquid injection attachment 1 and then the feed port 202 into the microchannel 201.

According to this liquid injection method, when injecting liquid into the feed port 202 by the pipette 100, the liquid injection attachment 1 may only be mounted on the distal portion 101 of the pipette 100 to thereby exert an excellent sealing performance without a risk to deform or damage the pipette 100 or the distal portion 101 thereof, making it possible to suppress the liquid leakage by the sealing function provided by the gasket 12 as well as to perform the liquid injection work in a simple manner. Commercial parts without gasket are available directly as the pipette 100 and the distal portion 101 thereof.

In the step of drawing and sampling liquid E contained in the sample container C, the liquid injection attachment 1 is not yet mounted on the distal portion 101 of the pipette 100 and therefore the liquid injection attachment 1 and the gasket 12 retained thereby are not dipped in liquid E within the sample container C. This prevents dripping attendant on the dipping from occurring.

Furthermore, this liquid injection method allows the use of the automatic pipette device or the pipetting robot for fitting together the distal portion 101 of the pipette 100 and the liquid injection attachment 1 or for forcing the pipette 100 against the microfluidic chip 200, enabling liquid to be injected by a simple system configuration. Automatization of injection is also feasible. Furthermore, use of the multichannel pipette enables liquid to be simultaneously injected into a plurality of microfluidic chips 200.

### EXPLANATIONS OF LETTERS OR NUMERALS

1,2,3,4A-4C,5,6: liquid injection attachment
11: attachment body
   11a: liquid outlet
   11b: insertion port
   11c: taper surface
   11d: stepped portion
   11e: distal end surface
   11f: stopper portion
   11g: connecting portion
   11h: distal end surface
12-15: gasket
   12a,13a: lip
   14a: gasket body
   14b: lip
   14c: distal end surface
100: pipette
   101: distal portion
   101a: distal end surface
   110: micropipette
   120: pipette tip
   121: distal portion
200: microfluidic chip
   200a: top surface
   201: microchannel
   202: feed port
C: sample container
E: liquid such as reagent

## Claims

1. A liquid injection attachment (1) adapted to be mounted removably on a pipette (100) or on a pipette tip (120) fitted to the pipette (100) for injecting liquid (E) into a feed port (202), comprising:
a tubular attachment body (11) having at its distal end a liquid outlet (11a) and having at its proximal end an insertion port (11b) for inserting a distal portion (101) of the pipette (100) or of the pipette tip (120); and
a gasket (13) formed from a rubber-like elastic body disposed around the liquid outlet (11a) of the tubular attachment body (11),
**characterised in that**
the attachment body (11) comprises at its distal end surface (11e) a stepped portion (11d) that is recessed so as to surround the liquid outlet (11a), with the gasket (13) being received in the stepped portion (11d) so as to protrude from the distal end surface (11e) of the attachment body (11).

2. The liquid injection attachment (1) of claim 1, wherein
h1>h2
where h1 is an axial height of the gasket (13) and h2 is an axial depth of the stepped portion (11d), and wherein
a difference Δh between h1 and h2 lies between a minimum allowable displacement and a maximum allowable displacement of the gasket (13).

3. The liquid injection attachment (1) of anyone of the preceding claims, wherein
the attachment body (11) is made of a synthetic resin.

4. The liquid injection attachment (1) of anyone of the preceding claims, wherein
an inner surface (11b) being closer to the insertion port (11b) than to the liquid outlet (11a) of the attachment body (11) has a taper surface (11c) that inclines so as to open outward from an axially midway portion toward the insertion port (11b).

5. A liquid injection method comprising the steps of:
drawing and sampling liquid (E) contained in a sample container by a pipette (100) or a pipette tip (120) fitted to the pipette (100);
mounting a liquid injection attachment (1) of any one of claims 1 to 4 on a distal portion (101) of the pipette (100) or the pipette tip (120);
forcing the pipette (100) or the pipette tip (120) mounted with the liquid injection attachment (1) toward a feed port (202) through which liquid (E) is introduced; and
injecting the liquid (E) from the pipette (100) or the pipette tip (120) into the feed port (202) by a compressed gas fed from the pipette (100),
the steps being executed in the mentioned order, wherein
when forcing the pipette (100) or the pipette tip (120) toward the feed port (202), the gasket (12, 13, 15) is compressively deformed to generate a reaction force that can counteract a liquid injection pressure, to consequently seal liquid (E) injected from the pipette (100) or the pipette tip (120) into the feed port (202).

## Patentansprüche

1. Flüssiginjektionsaufsatz (1), der eingerichtet ist, abnehmbar an einer Pipette (100) oder an einer auf die Pipette (100) aufgesetzte Pipettenspitze (120) befestigt zu werden, um Flüssigkeit (E) in einen Zufuhranschluss (202) einzuspritzen, aufweisend:
einen schlauchförmigen Aufsatzkörper (11), der an seinem distalen Ende einen Flüssigkeitsauslass (11a) und an seinem proximalen Ende einen Einschubanschluss (11b) aufweist, um einen distalen Abschnitt (101) der Pipette (100) oder der Pipettenspitze (120) einzuschieben; und
eine Dichtung (13), die aus einem gummiähnlichen, elastischen Körper gebildet ist, der um den Flüssigkeitsauslass (11) des schlauchförmigen Aufsatzkörpers (11) angeordnet ist,
**dadurch gekennzeichnet, dass**
der Aufsatzkörper (11) an seiner distalen Endfläche (11e) einen gestuften Abschnitt (11d) aufweist, der vertieft ist, um den Flüssigkeitsauslass (11a) zu umgeben, wobei die Dichtung (13) in dem gestuften Abschnitt (11d) aufgenommen wird, um von der distalen Endfläche (11e) des Aufsatzkörpers (11) hervorzustehen.

2. Flüssigkeitsinjektionsaufsatz (1) nach Anspruch 1, wobei
h1 > h2,
wobei h1 eine Axialhöhe der Dichtung (13) ist und h2 eine Axialtiefe des gestuften Abschnitts (11d) ist, und wobei
eine Differenz Δh zwischen h1 und h2 zwischen einer minimal zulässigen Verschiebung und einer maximal zulässigen Verschiebung der Dichtung (13) liegt.

3. Flüssigkeitsinjektionsaufsatz (1) nach einem der vorstehenden Ansprüche, wobei der Aufsatzkörper (11) aus einem Kunstharz gefertigt ist.

4. Flüssigkeitsinjektionsaufsatz (1) nach einem der vorstehenden Ansprüche, wobei eine Innenfläche (11b), die näher an dem Einschubanschluss (11b) als am Flüssigkeitsauslass (11a) des Aufsatzkörpers (11) liegt, eine verjüngte Fläche (11c) besitzt, die derart geneigt ist, dass sie von einem axial mittigen Abschnitt hin zum Einschubanschluss (11b) nach außen geöffnet wird.

5. Flüssigkeitsinjektionsverfahren, umfassend die Schritte:
Entnahme und Stichprobenkontrolle von Flüssigkeit (E) in einem Probenbehälter durch eine Pipette (100) oder eine Pipettenspitze (120), die auf die Pipette (110) aufgesetzt ist;
Befestigung eines Flüssigkeitsinjektionsaufsatzes (1) nach einem der Ansprüche 1 bis 4 an einem distalen Abschnitt (101) der Pipette (100) oder der Pipettenspitze (120);
Zwingen der Pipette (100) oder der Pipettenspitze (120), die an dem Flüssigkeitsinjektionsaufsatz (1) befestigt sind, hin zu einem Zufuhranschluss (202), durch den Flüssigkeit (E) eingeleitet wird; und
Injizieren der Flüssigkeit (E) aus der Pipette (100) oder der Pipettenspitze (120) in den Zufuhranschluss (202) durch ein aus der Pipette (100)zugeführtes verdichtetes Gas,
wobei die Schritte in der genannten Reihenfolge durchgeführt werden, wobei
wenn die Pipette (200) oder die Pipettenspitze (120) hin zu dem Zufuhranschluss (202) gezwungen werden, die Dichtung (12, 13, 15) unter Druck verformt wird, um eine Reaktionskraft zu erzeugen, die einem Flüssigkeitsinjektionsdruck entgegenwirken kann, um in der Folge aus der Pipette (100) oder der Pipettenspitze (120) in den Zufuhranschluss (202) injizierte Flüssigkeit (E) dicht zu verschließen.

## Revendications

1. Accessoire pour injection de liquide (1) conçu pour être monté de manière amovible sur une pipette (100) ou sur un embout de pipette (120) fixé sur la pipette (100) pour injecter du liquide (E) dans un orifice d'alimentation (202), comprenant :
un corps d'accessoire tubulaire (11) ayant au niveau de son extrémité distale une sortie de liquide (11a) et ayant au niveau de son extrémité proximale un orifice d'insertion (11b) pour insérer une partie distale (101) de la pipette (100) ou de l'embout de pipette (120) ; et
un joint d'étanchéité (13) formé à partir d'un corps élastique de type caoutchouc disposé autour de la sortie de liquide (11a) du corps d'accessoire tubulaire (11),
**caractérisé en ce que**
le corps d'accessoire (11) comprend au niveau de sa surface d'extrémité distale (11e) une partie à décrochement (11d) qui est évidée de manière à entourer la sortie de liquide (11a), le joint d'étanchéité (13) étant reçu dans la partie à décrochement (11d) de manière à faire saillie à partir de la surface d'extrémité distale (11e) du corps d'accessoire (11).

2. Accessoire pour injection de liquide (1) selon la revendication 1, où
h1>h2
où h1 est une hauteur axiale du joint d'étanchéité (13) et h2 est une profondeur axiale de la partie à décrochement (11d), et où
une différence Δh entre h1 et h2 se situe entre un déplacement permissible minimal et un déplacement permissible maximal du joint d'étanchéité (13).

3. Accessoire pour injection de liquide (1) selon l'une quelconque des revendications précédentes, le corps d'accessoire (11) étant fabriqué à partir d'une résine synthétique.

4. Accessoire pour injection de liquide (1) selon l'une quelconque des revendications précédentes, dans lequel
une surface interne (11b) qui est plus proche de l'orifice d'insertion (11b) que de la sortie de liquide (11a) du corps d'accessoire (11) a une surface conique (11c) qui s'incline de manière à s'ouvrir vers l'extérieur à partir d'une partie axialement médiane vers l'orifice d'insertion (11b).

5. Procédé d'injection de liquide comprenant les étapes :
d'aspirer et échantiller du liquide (E) contenu dans un contenant d'échantillon par une pipette (100) ou un embout de pipette (120) fixé sur la pipette (100) ;
de monter un accessoire pour injection de liquide (1) selon l'une quelconque des revendications 1 à 4 sur une partie distale (101) de la pipette (100) ou de l'embout de pipette (120) ;
de forcer la pipette (100) ou l'embout de pipette (120) monté avec l'accessoire pour injection de liquide (1) vers un orifice d'alimentation (202) par lequel du liquide (E) est introduit ; et
d'injecter le liquide (E) à partir de la pipette (100) ou de l'embout de pipette (120) dans l'orifice d'alimentation (202) par un gaz comprimé introduit à partir de la pipette (100),
les étapes étant exécutées dans l'ordre indiqué, où
lorsque l'on force la pipette (100) ou l'embout de pipette (120) vers l'orifice d'alimentation (202), le joint d'étanchéité (12, 13, 15) est déformé en compression pour générer une force de réaction qui peut contrecarrer une pression d'injection de liquide, afin de étanchéifier du liquide (E) injecté à partir de la pipette (100) ou de l'embout de pipette (120) dans l'orifice d'alimentation (202).
